# EUROPEAN PATENT SPECIFICATION

(11) **EP 0 277 818 B1**
(45) Date of publication and mention of the grant of the patent: **29.09.1993**
(21) Application number: 88300896.3
(22) Date of filing: 03.02.1988
(51) Int. Cl.: H05K 9/00

(54) **Electromagnetic shielding panel**
Platte zur elektromagnetischen Abschirmung
Panneau pour blindage électromagnétique

(30) Priority: 03.02.1987 GB 8702357
(43) Date of publication of application: 10.08.1988
(73) Proprietor: PILKINGTON PLC, St. Helens, Merseyside WA10 3TT (GB)
(72) Inventor: Clarke, Leslie Thomas, Wirral Merseyside L47 1HY (GB); Davies, Mervyn John Flat 5 Oxford Court, Southport Merseyside PR8 2EA (GB)
(74) Representative: Pendlebury, Anthony

(56) References cited:
- EP-A- 0 200 452
- EP-A- 0 226 151
- GB-A- 2 129 831
- US-A- 4 459 470

## Description

The invention relates to electromagnetic shielding panels and, in particular, to translucent electromagnetic shielding panels comprising a pane of coated glass.

Glass and transparent plastics are translucent to short wave electromagnetic radiation, i.e. radiation having a frequency in the range 20 to 10000 MHz, so that stray emissions from electronic data processing equipment can escape through windows and be detected outside. Such escape prejudices the security of the information being processed. Moreover, entry of extraneous electromagnetic signals, such as radar signals, through the windows of rooms housing electronic data processing equipment can effect the proper operation of the equipment.

It is known that the transmission of short wave electromagnetic radiation through windows can be prevented or at least reduced by providing the window with a continuous electroconductive layer and earthing the layer all around the periphery of the window to provide an electromagnetic shielding window.

A number of glass products incorporating electroconductive layers have been offered for use in electromagnetic shielding windows. One such product is glass carrying an indium tin oxide coating having a sheet resistance in the range 4 to 6 ohms per square. Such coatings may be deposited by reactive sputtering but, in order to obtain the high conductivity (low resistance) required, it is necessary to heat the glass substrate. Suitable apparatus for coating large areas of glass is expensive; the coatings are therefore generally deposited in relatively small areas and are expensive to apply.

Another known product is laminated glass incorporating a layer of fine metal mesh in a plastics interlayer between two panes of glass. Unfortunately, the mesh not only reduces the light transmission through the laminate but also obscures the view. Moreover, because the fine metal mesh is expensive, laminates incorporating the mesh are expensive to produce.

It has also been proposed to apply a polyester film carrying a sputtered coating of a metal or metal alloy such as titanium, stainless steel, bronze, sterling silver or 24 carat gold to glass with the coated face of the film towards the glass to provide an electromagnetic shield. Unfortunately, it is difficult to make electrical contact with the coating on the film without damaging the film, so that there are problems in earthing the coating.

An electromagnetic shielding panel is known from EP-A-0200452, in which an electroconductive coating comprising a mixture of indium oxide and tin oxide is arranged on a coated plastics base plate, with an anti-reflection film arranged over the electroconductive layer. Electrical connection to the electroconductive layer is made through a metal frame or wire.

There is a need for a high performance translucent electro magnetic shielding panel which can be produced economically with good optical properties.

According to the present invention there is provided a translucent electromagnetic shielding panel comprising in combination:
a transparent substrate
electrically conductive means for providing a light translucent shield against electromagnetic radiation, consisting solely of a conductive layer coating said substrate; and
electrical connection means in electrical contact with the conductive layer all around its periphery;
characterised in that said substrate is glass, and said conductive layer is a layer of silver having a thickness in the range 15 nm to 50 nm and which is sandwiched between anti-reflection layers of metal oxide, the outer layer constituting a protective layer.

The use of the silver coated glass referred to herein as a light translucent shield against electromagnetic radiation having a frequency in the range 20 MHz to 10000 MHz (see claim 14) or in the range of 200 MHz to 10000 MHz (see claim 15), is novel and forms part of the present invention.

The use of a silver layer having a thickness of at least 15 nm enables a coating with a sheet resistance of less than 5 ohms per square to be achieved. Preferred coatings have a silver layer at least 22.5 nm thick to provide even lower sheet resistance. Unfortunately, the thicker the silver layer, the greater the cost of the coating and the lower the light transmission of the coated glass. Thus the silver layer preferably has a thickness of less than 40 nm. Especially preferred coatings have a silver layer having a thickness in the range 22.5 nm to 30 nm.

To enhance the light transmission of the coated glass, the silver layer is sandwiched between anti-reflection layers of metal oxide, the outer layer also serving to protect the silver. Examples of metal oxide which may be used include titanium oxide, tin oxide, indium tin oxide, zinc oxide and bismuth oxide. The anti-reflection layers will generally each have a thickness in the range 20 nm to 60 nm. It is preferred to use tin oxide for the anti-reflection layers and, for optimum light transmission, the tin oxide layers will each have a thickness in the range 30 nm to 50 nm depending on the thickness of the silver layer.

The silver coatings referred to above can be deposited by magnetically enhanced sputtering as described in UK patent GB 2 129 831B.

The silver coatings are not very durable and are preferably protected by incorporating the coated pane in a laminate, or alternatively, a multiple glazing unit, with the coating facing inwards.

It will usually be necessary for the electrical connection means to be a mechanical coupling in order to achieve the required electrical connection with the coating. To achieve superior reductions in electromagnetic radiation, through the electromagnetic shielding panel, a direct mechanical coupling is generally necessary between an electroconductive surround means in the form of a metal frame supporting the glass and the coating. The electrical connection means in this case may take the form of a fine mesh or bus bar. However, in some cases electrical connection means in the form of a capacitive coupling between the coating and the metal frame (preferably overlapping the coating), around the periphery of the coated glass may provide sufficient electrical coupling, and a direct mechanical coupling using either the mesh or bus bar technique will be unnecessary. The metal frame may, if required, be electrically coupled to earth.

In the circumstances when a capacitive coupling is employed, the attenuation offered by the panel to electromagnetic radiation may vary considerably in dependence upon the thickness of the glass employed, the type of metal frame supporting the glass (i.e. the degree of overlap with the coating), and the frequency range of electromagnetic radiation concerned.

As a general guide, however, it is possible to obtain substantial attenuation of electromagnetic radiation with capacitive coupling in the range from 200 MHz upwards to 10,000 MHz averaging between 20 to 25dB. These attenuation figures progressively reduce at frequencies below 200 MHz.

When electrical connection means in mechanical contact with the coating is used to provide the required electrical contact with the coating at least partly around the periphery of the coating, the electrical connection means may be, for example, in the form of bus bars; the bus bars may be printed onto the coated glass using a UV-curable electronconductive epoxy ink and the ink cured by exposure to ultra-violet light. The bus bars may extend around the edges of the glass pane to its opposite face. The high contact resistance between the bus bars and the silver layer of the coating (resulting from the presence of the protective layer over the silver) may be reduced by applying a high voltage between the coating and the bus bars (as described, for example, in US patent 4,459,470). In another form of the invention, the coated glass is laminated with its coated face inwards to protect the coating, and a border of fine electroconductive mesh, for example fine wire mesh, is sandwiched between a plastics interlayer and the coating in electrical contact with the silver layer around the whole periphery of the coating.

The invention is illustrated but not limited by the following description of the production of a translucent electromagnetic shielding panel in accordance with the invention.

A sheet of 3 mm clear float glass was coated by a magnetically enhanced sputtering process as described in UK patent GB 2,129,831B.

The glass pane was washed and dried and loaded into an Airco ILS 1600 D.C. planar magnetron sputtering apparatus. Tin oxide (SnO₂) was reactively sputtered on to the glass from a tin cathode in the presence of an oxygen atmosphere at 0.66 Pa (5 x 10⁻³ torr) to give a tin oxide layer approximately 35 nm thick. A layer of silver approximately 25 nm thick was then sputtered onto the tin oxide from a silver cathode in the presence of an argon atmosphere at 0.53 Pa (4 x 10⁻³ torr), and aluminium in an amount equivalent to a layer approximately 2 nm thick was sputtered over the silver from an aluminium cathode in the presence of an argon atmosphere at 0.53 Pa ( 4 x 10⁻³ torr), Finally, a layer of tin oxide approximately 38 nm thick was reactively sputtered over the aluminium from a tin cathode in the presence of an oxygen atmosphere at 0.66 Pa (5 x 10⁻³ torr).

The coating produced was analysed by Auger electron spectroscopy, as described in UK patent GB 2 129 831B, and the thickness of the various layers estimated from the resultant spectrum as follows:

| | |
|---|---|
| Lower tin oxide layer | 35 nm |
| Silver layer | 25 nm |
| Aluminium oxide layer | 7 nm (equivalent to a layer of aluminium 2 to 3 nm thick) |
| Outer tin oxide layer | 34 nm |

The sheet resistance of the coating was measured by the 4 point probe method, and the optical properties of the coated glass were measured using light from a CIE Illuminant C Source on the side of the glass remote from the coating:

| | |
|---|---|
| Light transmission | 52% |
| Light reflection | 33% |
| Direct solar heat transmission | 29% |
| Solar heat reflection | 49% |
| Solar heat absorption | 22% |
| Total solar heat transmission | 33% |
| Emissivity of coating | 0.015 |
| Sheet resistance | 2.5-3.0 ohms per square |

A pane 1500 mm x 450 mm was cut from the coated sheet and laminated to a 3 mm pane of clear float glass with an interlayer of polyvinylbutyral. Strips of fine electroconductive wire mesh were incorporated in the laminate in electrical contact with the coating along all four sides of the pane to form a border in electrical contact with the coating around the periphery of the coated pane. The resultant laminate, and its production from the coated pane, will now be described with reference to the accompanying drawings in which
Figure 1 is a plan view of a translucent electromagnetic shielding panel in accordance with the invention in the form of a laminate;
Figure 2 is a section on an enlarged scale on the line II-II in Figure 1;
Figure 3 shows a section of a laminate as shown in Figure 1 mounted in a supporting frame illustrating direct mechanical contact using fine mesh;
Figure 4 shows the same section as Figure 3 illustrating direct mechanical contact using bus bars; and,
Figure 5 shows the same section as Figure 4 illustrating diagrammatically the capacitive coupling arrangement.

The laminate, generally designated 1, comprises a first pane of glass 2 carrying the electroconductive coating 3. Four strips of fine electroconductive mesh, 4,5,6 and 7 lie along the edges of the laminate in electrical contact with the coating 3 and forming a border around the periphery of the laminate. The strips 4,5,6 and 7 extend beyond the edges of the pane 1 around the whole periphery of the coated pane, and overlap slightly at the corners to ensure there are no gaps between them.

The electroconductive mesh is embedded in a plastics interlayer 8 over the coated surface of the glass, and the plastics interlayer is, in turn, covered by a pane of uncoated glass 9. The electroconductive mesh extends beyond the edge of the laminate around the whole periphery of the laminate, enabling the coating to be earthed around its periphery, for example, by glazing in a window frame or support means for the glass of electroconductive metal with the electroconductive mesh in contact with the metal around the whole periphery of the laminate.

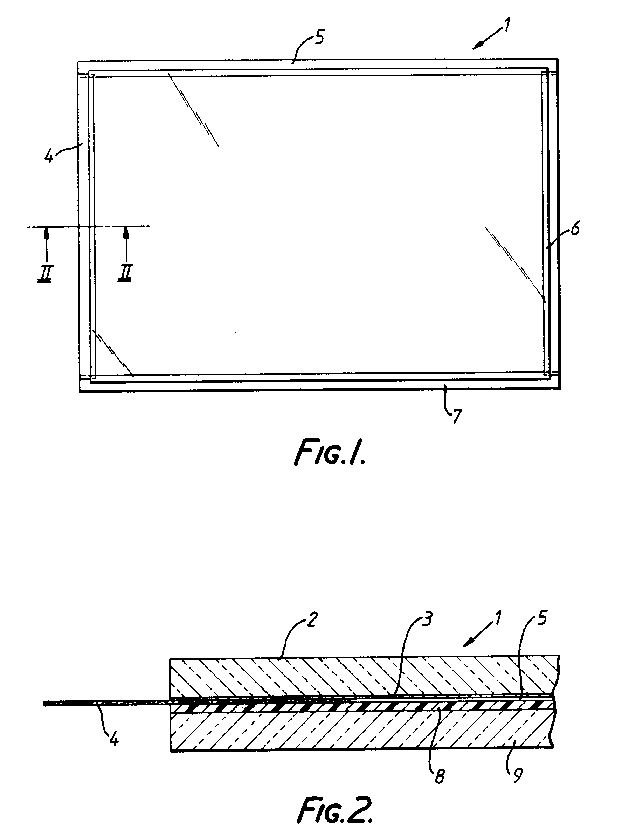

To produce the laminate, a pane of uncoated 3 mm clear float glass was cut to the same plan size as the coated pane referred to above and a rectangular sheet of 0.76 mm polyvinylbutyral, also 1500 mm x 450 mm, was laid over the uncoated pane in register with the pane. Four strips of WRAPSHIELD (Registered Trade Mark) knitted wire mesh 25 mm wide and 0.4 mm thick were cut to length and laid along the edges of the pane as indicated in Figure 1, with a small overlap at the corners. The strips were laid so as to overlap the uncoated glass pane by 10 mm and extend 15 mm beyond the edges of the pane. (The WRAPSHIELD (Registered Trade Mark) mesh used was a knitted mesh of tin plated, copper clad steel wire, and had a mesh size of about 1 mm. It is available in commerce from RFI Shielding Limited of Braintree, Essex, England). A soldering iron was used to weld the polyvinylbutyral to the metal mesh at intervals around the periphery of the polyvinylbutyral. The cut pane of coated 3 mm clear float glass, 1500 mm x 450 mm, was then placed over the polyvinylbutyral and the mesh, in register with the polyvinylbutyral and the uncoated glass pane, and the assembly so formed 'pre-nipped' by passing it between a series of pairs of opposed press rollers with radiant heaters between adjacent pairs of rollers. The assembly was heated to a temperature in the range 120°C to 130°C and pressed under a load of 560kPa (80 psi). It was then heated in an autoclave at a temperature of 135°C and a pressure of 630kPa (90 psi) to form a laminate with good electrical contact between the metal mesh and the coating. (To check the electrical contact, a similar laminate was produced with the strips of electroconductive along two opposite edges only. The contact resistance between the strips of mesh and the electroconductive coating was found to be 1 ohm).

The resultant laminate constituted a high performance translucent electromagnetic shielding panel in accordance with the invention, with an attenuation of over 30 decibels throughout the range 20 to 10,000 MHz (when mechanically connected), and an attenuation of over 40 decibels in the range 20 to 90 MHz (when mechanically connected). The laminate, in common with the unlaminated coated glass, also has extremely beneficial optical properties as set out below:

| | |
|---|---|
| Light transmission | 42% |
| Light reflection | 42% |
| Direct solar heat transmission | 25% |
| Solar heat reflection | 51% |
| Solar heat absorption | 24% |
| Total solar heat transmission | 33% |

(measured using a CIE Illuminant C Source, with the uncoated surface of the coated pane towards the source).

It will be noted that, for both the free standing coated glass and the laminated coated glass having a silver layer of thickness 15 nm to 50 nm (preferably 22.5 nm to 30 nm) sandwiched between anti-reflection metal oxide layers, the light transmission is greater than the solar heat transmission. Thus the coated glasses referred to herein are useful not only in electromagnetic shielding panels, but also for high performance solar control glazings.

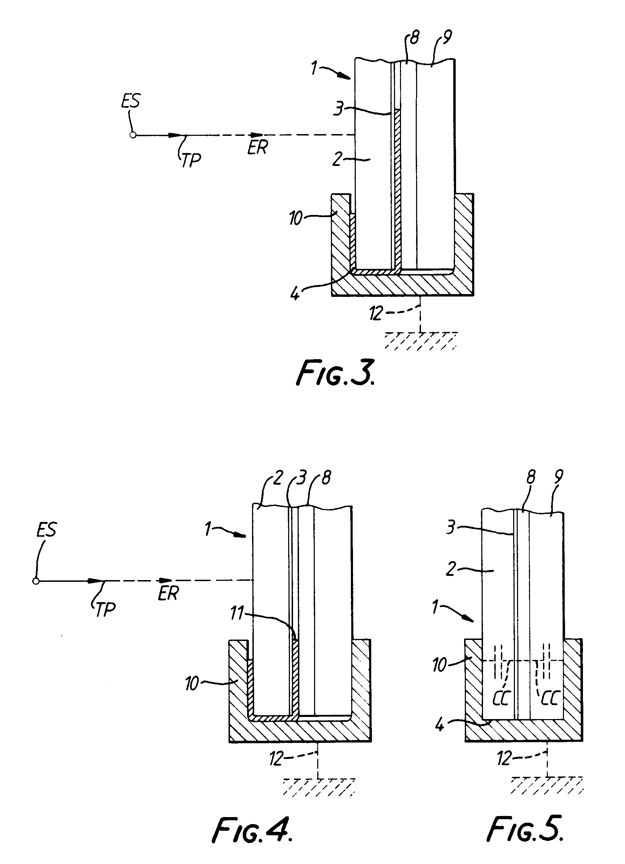

It will be seen by reference to Figure 3 and Figure 4, how the electrical connection means is a direct mechanical coupling in the form of a fine mesh 4 (as shown in Figure 3) and a bus bar 11 (as shown in Figure 4) in electrical contact with the coating 3. It will also be seen how the mesh 4 and bus bar 11 are in electrical contact with the metal frame 10. This frame may, if required, also be electrically coupled to earth as indicated by reference 12. When using a bus bar as illustrated in Figure 4, an electrically conductive, flexible gasket (comprising typically a fine metal mesh or metal loaded rubber) may be sandwiched between the metal frame 10 and the bus bars 11 to improve the electrical contact with the frame.

By referring to Figure 5, is will be seen that when either the mesh 4 or the bus bars 11 are not used, the electrical connection is constituted by a capacitive coupling means CC inherently present between the coating 3 and the electroconductive surround means 10. As previously mentioned, this capacitive coupling arrangement is quite sufficient to provide sufficient electrical coupling for the electromagnetic shielding panel to provide substantial attenuation of electromagnetic radiation in the range from 200 MHz upwards to 10,000 MHz. Attenuation in these circumstances is 20db to 25 db.

From Figure 3 and Figure 4, it can also be seen how electromagnetic radiation source ES follows a transmission path TP towards the electromagnetic shielding panel 1. The panel 1 attenuates the electromagnetic radiation, as has previously been discussed, in such a manner that the electromagnetic radiation on the side of the panel opposite the radiation source ES is substantially reduced.

## Claims

1. A translucent electromagnetic shielding panel (1) comprising in combination:
a transparent substrate (2)
electrically conductive means for providing a light translucent shield against electromagnetic radiation, consisting solely of a conductive layer (3) coating said substrate; and
electrical connection means (4,5,6,7;11; cc) in electrical contact with the conductive layer (3) all around its periphery;
characterised in that said substrate is glass, and said conductive layer (3) is a layer of silver having a thickness in the range 15 nm to 50 nm and which is sandwiched between anti-reflection layers of metal oxide, the outer layer constituting a protective layer.

2. A panel as claimed in claim 1, wherein the silver layer (3) has a thickness between 20 nm to 30 nm.

3. A panel as claimed in claim 1 wherein the silver layer (3) has a thickness of at least 22.5 nm.

4. A panel as claimed in any preceding claim wherein the anti-reflection layers are of tin oxide.

5. A panel as claimed in claim 4 wherein each tin oxide anti-reflection layer has a thickness in the range 30 nm to 50 nm.

6. A panel as claimed in any one of claims 1 to 5 which is a laminated panel including a plastics interlayer (8) which overlies said silver layer (3) and said protective metal oxide layer, and a further pane of glass (9) which overlies said plastics interlayer (8), wherein said silver layer (3) and the protective layer over said silver layer (3) face inwards of the laminated panel, and said electrical connection means (4,5,6,7;11 cc) is sandwiched between said plastics interlayer (8) and said protective layer to make electrical contact with said silver layer around its whole periphery.

7. A panel as claimed in any one of claims 1 to 5, in combination with a further pane of glass arranged to form a multiple glazing unit with the silver face of the coated panel (2) facing inwards of the multiple glazing unit, wherein the electrical connection means (4,5,6,7;11; cc) is in electrical contact with the silver layer around the whole periphery of the coating.

8. A panel as claimed in claim 6 or 7, in which the electrical connection means comprises bus bars (11) in electrical contact with the silver layer (3) around the periphery of the coating.

9. A panel as claimed in claim 8, in which the bus bars (11) extend around the edges of the coated glass pane (2) to its opposite face.

10. A panel as claimed in claims 6 or 7 in which the electrical connection means comprises a border of fine electroconductive mesh (4,5,6,7) in electrical contact with the silver layer (3) around the periphery of the coating.

11. A panel as claimed in claim 10, wherein the border of electro-conductive mesh (4,5,6,7) extends beyond the edges of the coated pane along each side of the coated pane (2).

12. A panel as claimed in any one of the preceding claims which comprises additionally an electroconductive surround means (10) for supporting the pane of glass (2), wherein the electrical connection means (4,5,6,7)(11)(cc) provides an electrically conductive path between the silver layer (3) and the electroconductive surround means (10) for electromagnetic radiation (ER) captured by the panel (1).

13. A panel as claimed in any of claims 1 to 5 in an electroconductive surround means (10) in which the electrical connection means is constituted by capacitive coupling (cc) between the coating and the electroconductive surround means (10).

14. The use of a panel as claimed in any of claims 1 to 12 as a light translucent shield against electromagnetic radiation (ER) having a frequency in the range 20 MHz to 10000 MHz.

15. The use of a panel as claimed in any of claims 1 to 13 as a light translucent shield against electromagnetic radiation (ER) having a frequency in the range 200 MHz to 10000 MHz.

16. A panel as claimed in claims 12 or 13 wherein the electroconductive surround means (10) is coupled to earth (12) and wherein the insertion of said panel in the transmission path (TP) of electromagnetic radiation (ER) emanating from an electromagnetic radiation source (ES) provides a substantial reduction in the electromagnetic radiation (ER) present on the side of the panel opposite the said radiation source (ES) and provides an electrically conductive path to earth (12) for said electromagnetic radiation (ER).

## Patentansprüche

1. Lichtdurchlässige elektromagnetische Abschirmplatte (1) mit:
einem transparenten Substrat (2);
einer elektrisch leitenden Einlichtung zur Erzielung einer lichtdurchlässigen Abschirmung gegen elektromagnetische Strahlung, die nur aus einer leitfähigen Schicht (3) bestehen, die das Substrat abdeckt; und
einer elektrischen Verbindungseinrichtung (4, 5, 6, 7; 11; cc) in elektrischem Kontakt mit der leitfähigen Schicht (3) entlang ihres gesamten Umfangs;
**dadurch gekennzeichnet,**
daß das Substrat Glas ist und daß die leitfähige Schicht (3) eine Schicht aus Silber mit einer Dicke im Bereich von 15 bis 50 nm ist, die zwischen. Antireflexschichten aus Metalloxid angeordnet ist, von denen die äußere Schicht eine Schutzschicht bildet.

2. Platte nach Anspruch 1, dadurch gekennzeichnet, daß die Silberschicht (3) eine Dicke zwischen 20 und 30 nm hat.

3. Platte nach Anspruch 1, dadurch gekennzeichnet, daß die Silberschicht (3) eine Dicke von mindestens 22,5 nm hat.

4. Platte nach einem der vorhergehenden Ansprüche, dadurch gekennzeichnet, daß die Antireflexschichten aus Zinnoxid bestehen.

5. Platte nach Anspruch 4, dadurch gekennzeichnet daß jede Zinnoxid-Antireflexschicht eine Dicke im Bereich von 30 bis 50 nm hat.

6. Platte nach einem der Ansprüche 1 bis 5, die eine laminierte Platte ist, mit einer Kunststoffzwischenschicht (8), die die Silberschicht (3) und die Metalloxidschutzgchicht überdeckt, und einer weiteren Glasscheibe (9), die die Kunststoffzwischenschicht (8) überdeckt, dadurch gekennzeichnet, daß die Silberschicht (3) und die Schutzschicht über der Silberschicht (3) zum Inneren der laminierten Platte hin liegen und daß die elektrische Verbindungseinrichtung (4, 5, 6, 7; 11; cc) zwischen der Kunststoffzwischenschicht (8) und der Schutzschicht angeordnet ist, um elektrischen Kontakt mit der Silberschicht entlang ihres gesamten Umfangs herzustellen.

7. Platte nach einem der Ansprüche 1 bin 5, in Kombination mit einer weiteren Glasscheibe, die angeordnet ist, um eine Mehrfachverglasungseinheit zu bilden, wobei die versilberte Seite der beschichteten Platte (2) zum Inneren der Mehrfachverglasungseinheit hin liegt, dadurch gekennzeichnet, daß die elektrische Verbindungseinrichtung (4, 5, 6, 7; 11; cc) entlang des gesamten Umfangs der Beschichtung in elektrischem Kontakt mit der Silberschicht steht.

8. Platte nach Anspruch 6 oder 7, bei der die elektrische Verbindungseinrichtung Sammelschienen (11) in elektrischem Kontakt mit der Silberschicht (3) entlang des Umfangs der Beschichtung umfaßt.

9. Platte nach Anspruch 8, bei der die Sammelschienen (11) sich entlang der Kanten der beschichteten Glasscheibe (2) bis zu ihrer gegenüberliegenden Seite erstrecken.

10. Platte nach Anspruch 6 oder 7, bei der die elektrische Verbindungseinrichtung einen Rand aus einem elektrisch leitenden Gewebe (4, 5, 6, 7) in elektrischem Kontakt mit der Silberschicht (3) entlang des Umfangs der Beschichtung umfaßt.

11. Platte nach Anspruch 10, dadurch gekennzeichnet, daß der Rand des elektrisch-leitenden Gewedes (4, 5, 6, 7) sich über die Kanten der beschichteten Scheibe entlang jeder Seite der beschichteten Scheibe (2) hinaus erstreckt.

12. Platte nach einein der vorhergehenden Ansprüche, die zusätzlich eine elektrisch leitende Einfassungseinrichtung (10) zur Unterstützung der Glasscheibe (2) umfaßt, dadurch gekennzeichnet, daß die elektrische Verbindungseinrichtung (4, 5, 6, 7, 11; cc) einen elektrisch leitenden Weg zwischen der Silberschicht (3) und der elektrisch leitenden Umfassungseinrichtung (10) für von der Platte eingefangene elektromagnetische Strahlung (ER) bildet.

13. Platte nach einem der Ansprüche 1 bis 5 in einer elektrisch leitenden Umfassungseinrichtung (10), bei der die elektrische Verbindungseinrichtung durch kapazitive Kopplung (cc) zwischen der Beschichtung und der elektrisch leitenden Umfassungseinrichtung (10) gebildet wird.

14. Verwendung einer Platte nach einem der Ansprüche 1 bis 12 als lichtdurchlässige Abschirmung gegen elektromagnetische Strahlung (ER) mit einer Frequenz im Bereich von 20 bis 10000 MHz.

15. Verwendung einer Platte nach einem der Ansprüche 1 bis 13 als lichtdurchlässige Abschirmung geben elektromagnetische Strahlung (ER) mit einer Frequenz im Bereich von 200 MHz bis 10000 MHz.

16. Platte nach Anspruch 12 oder 13, dadurch gekennzeichnet, daß die elektrisch leitende Umfassungseinrichtung (10) mit Erde (12) verbunden ist und daß die Einfügung der Platte in den Transmissionsweg (TP) von aus einer elektromagnetischen Strahlungsquelle (ES) austretender elektromagnetischer Strahlung (ER) eine wesentliche Verringerung der elektromagnetischen Strahlung (ER) auf der von der Strahlungsquelle (ES) abgewandten Seite der Platte bewirkt und einen elektrisch leitenden Weg zur Erde (12) für die elektromagnetische Strahlung (ER) bildet.

## Revendications

1. Panneau de blindage électromagnétigue translucide (1) comprenant en combinaison :
un substrat transparent (2) ;
un moyen conducteur de l'électricité pour fournir un blindage, contre les radiations électromagnétiques, transmettant la lumière, constitué simplement d'une couche conductrice (3) revêtant ledit substrat ; et,
un moyen de connexion électrique (4, 5, 6, 7 ; 11 ; cc) en contact électrique avec la couche conductrice (3) tout autour de sa périphérie ;
caractérisé en ce que ledit substrat est fait de verre, et en ce que ladite couche conductrice (3) est une couche d'argent ayant une épaisseur de l'ordre de 15 nm à 50 nm, qui est prise en sandwich entre des couches d'oxyde métallique anti-reflets, la couche extérieure constituant une couche protectrice.

2. Panneau selon la revendication 1, dans lequel la couche d'argent (3) a une épaisseur située entre 20 nm et 30 nm.

3. Panneau selon la revendication 1, dans lequel la couche d'argent (3) a une épaisseur d'au moins 22,5 nm.

4. Panneau selon l'une quelconque des revendications précédentes, dans lequel les couches anti-reflets sont faites d'oxyde d'étain.

5. Panneau selon la revendication 4, dans lequel chaque couche d'oxyde d'étain anti-reflets a une épaisseur de l'ordre de 30 nm à 50 nm.

6. Panneau selon l'une quelconque des revendications 1 à 5 qui est un panneau stratifié incluant une couche intermédiaire en plastique (8) qui recouvre ladite couche d'argent (3) et ladite couche protectrice d'oxyde métallique, et une plaque de verre (9) supplémentaire qui recouvre ladite couche intermédiaire en plastique (8) dans lequel ladite couche d'argent (3) et la couche protectrice sur ladite couche d'argent (3) font face vers l'intérieur du panneau stratifié, et dans lequel ledit moyen de connexion électrique (4, 5, 6, 7 ; 11 ; cc) est pris en sandwich entre ladite couche intermédiaire en plastique (8) et ladite couche protectrice pour faire contact électrique avec ladite couche d'argent tout autour de sa périphérie.

7. Panneau selon l'une quelconque des revendications 1 à 5, en combinaison avec une plaque de verre supplémentaire agencée de manière à former une unité de vitrage multiple, la face argentée du panneau revêtu (2) faisant face vers l'intérieur de l'unité de vitrage multiple, dans lequel le moyen de connexion électrique (4, 5, 6, 7 ; 11 ; cc) est en contact électrique avec la couche d'argent tout autour de la périphérie du revêtement.

8. Panneau selon la revendication 6 ou 7, dans lequel le moyen de connexion électrique comprend des barres collectrices (11) en contact électrique avec la couche d'argent (3) autour de la périphérie du revêtement.

9. Panneau selon la revendication 8, dans lequel les barres collectrices (11) s'étendent autour des bords de la plaque de verre revêtue (2) jusqu'à sa face opposée.

10. Panneau selon la revendication 6 ou 7, dans lequel le moyen de connexion électrique comprend une bordure en treillis fin (4, 5, 6, 7), conducteur de l'électricité, en contact électrique avec la couche d'argent (3) autour de la périphérie du revêtement.

11. Panneau selon la revendication 10, dans lequel la bordure en treillis (4, 5, 6, 7), conducteur de l'électricité, s'étend au-delà des bords de la plaque revêtue le long de chaque côté de la plaque revêtue (2).

12. Panneau selon l'une quelconque des revendications précédentes qui comprend en plus un moyen d'encadrement (10), conducteur de l'électricité, pour supporter la plaque de verre (2), dans lequel le moyen de connexion électrique (4, 5, 6, 7) (11) (cc) fournit un trajet conducteur de l'électricité entre la couche d'argent (3) et le moyen d'encadrement (10), conducteur de l'électricité, pour la radiation électromagnétique (ER) captée par le panneau (1).

13. Panneau selon l'une quelconque des revendications 1 à 5, dans un moyen d'encadrement (10), conducteur de l'électricité dans lequel le moyen de connexion électrique est constitué par un couplage capacitif (cc) entre le revêtement et le moyen d'encadrement (10) conducteur de l'électricité.

14. Utilisation d'un panneau selon l'une quelconque des revendications 1 à 12, comme blindage, transmettant la lumière, contre une radiation électromagnétique (ER) ayant une fréquence de l'ordre de 20 MHz à 10.000 MHz.

15. Utilisation d'un panneau selon l'une quelconque des revendications 1 à 13, comme blindage, transmettant la lumière, contre une radiation électromagnétique (ER) ayant une fréquence de l'ordre de 200 MHz à 10.000 MHz.

16. Panneau selon l'une quelconque des revendications 12 ou 13, dans lequel le moyen d'encadrement (10), conducteur de l'électricité, est relié à la terre (12) et dans lequel l'insertion dudit panneau dans le trajet de transmission (TP) de la radiation électromagnétique (ER) émanant d'une source de radiations électromagnétiques (ES) fournit une réduction sensible de la radiation électromagnétique (ER) présente du côté du panneau opposé à ladite source de radiations (ES) et fournit, à ladite radiation électromagnétique (ER), un trajet conducteur de l'électricité jusqu'à la terre (12).
